# EUROPEAN PATENT APPLICATION

(11) **EP 3 637 234 A1**
(43) Date of publication of application: **15.04.2020**
(21) Application number: 19197585.3
(22) Date of filing: 16.09.2019
(51) Int. Cl.: G06F 3/041, G06F 3/042

(54) **DISPLAY DEVICE**

(30) Priority: 09.10.2018 US 201862743099 P; 25.04.2019 US 201916395197
(71) Applicant: InnoLux Corporation, Chu-Nan, Miao-Li 350 (TW)
(72) Inventor: LIUS, CHANDRA, 350 Miao-Li County (TW); Lee, Kuan-Feng, 350 Miao-Li County (TW)
(74) Representative: Straus, Alexander

(57) **Abstract**

A display device (101, 102, 103, 104, 105, 106, 107, 108, 109, 110, or 111) includes a substrate (10), a driving circuit (CC1), sensing units (SU), and a sensing circuit (CC2). The driving circuit (CC1) is disposed on the substrate (10) and is configured for driving display units (DU). The sensing units (SU) are disposed on the driving circuit (CC1) and include a first semiconductor layer (40). The sensing circuit (CC2) is configured for driving the sensing units (SU) and includes a second semiconductor layer (32 or 16). A thickness of the first semiconductor layer (40) is greater than a thickness of the second semiconductor layer (32 or 16).

## Description

### Field of the Invention

The present disclosure relates to a display device, and more particularly, to a display device including display units and sensing units.

### Background of the Invention

Because of certain advantages, such as light weight or low volume, display panels are widely used in electronic devices. However, as many other functions (except display) have to be applied to the electronic device, the volume or the weight of the electronic device may increase, and that may influence the portability and appearance of the electronic device.

### Summary of the Invention

As will be seen more clearly from the detailed description following below, the claimed display device includes a substrate, a driving circuit, a plurality of sensing units, and a sensing circuit. The driving circuit is disposed on the substrate and is configured for driving a plurality of display units. The sensing units are disposed on the driving circuit and include a first semiconductor layer. The sensing circuit is configured for driving the sensing units and includes a second semiconductor layer. A thickness of the first semiconductor layer is greater than a thickness of the second semiconductor layer.

### Brief Description of the Drawings

In the following, the disclosure is further illustrated by way of example, taking reference to the accompanying drawings. Thereof
FIG. 1 is a schematic drawing illustrating a display device according to a first embodiment of the present disclosure,
FIG. 2 is a schematic circuit diagram of a sensing circuit according to the first embodiment of the present disclosure,
FIG. 3 is a schematic circuit diagram of a driving circuit according to the first embodiment of the present disclosure,
FIG. 4 is a schematic top view drawing illustrating a display device according to an embodiment of the present disclosure,
FIG. 5 is a schematic drawing illustrating a display device according to a second embodiment of the present disclosure,
FIG. 6 is a schematic drawing illustrating a display device according to a third embodiment of the present disclosure,
FIG. 7 is a schematic circuit diagram of a driving circuit according to the third embodiment of the present disclosure,
FIG. 8 is a schematic drawing illustrating a display device according to a fourth embodiment of the present disclosure,
FIG. 9 is a schematic circuit diagram of a sensing circuit according to the fourth embodiment of the present disclosure,
FIG. 10 is a schematic drawing illustrating a display device according to a fifth embodiment of the present disclosure,
FIG. 11 is a schematic drawing illustrating a display device according to a sixth embodiment of the present disclosure,
FIG. 12 is a schematic drawing illustrating a display device according to a seventh embodiment of the present disclosure,
FIG. 13 is a schematic drawing illustrating a display device according to an eighth embodiment of the present disclosure,
FIG. 14 is a schematic drawing illustrating a display device according to a ninth embodiment of the present disclosure,
FIG. 15 is a schematic drawing illustrating a display device according to a tenth embodiment of the present disclosure, and
FIG. 16 is a schematic drawing illustrating a display device according to an eleventh embodiment of the present disclosure.

### Detailed Description

The present disclosure has been particularly shown and described with respect to embodiments and specific features thereof. The embodiments set forth herein below are to be taken as illustrative rather than limiting. It should be readily apparent to those of ordinary skill in the art that various changes and modifications in form and detail may be made without departing from the spirit and scope of the present disclosure.

Before the further description of the embodiments, the specific terms used throughout the text will be described below.

The terms "on," "above," and "over" used herein should be interpreted in the broadest manner such that "on" not only means "directly on" something but also includes the meaning of "on" something with an intermediate feature or a layer therebetween, and that "above" or "over" not only means the meaning of "above" or "over" something but can also include the meaning it is "above" or "over" something with no intermediate feature or layer therebetween (i.e., directly on something).

Additionally, terms, such as "bottom", "below", "above", "top", and the like, may be used herein for ease of description to describe one element or feature's relationship to another element(s) or feature(s) as illustrated in the figures. If the device in the figures in turned over, elements described as "above" can become "below". It will be understood that spatially relative terms are intended to encompass different orientations of the device in use or operation in addition to the orientations depicted in the figures.

The term "forming" or the term "disposing" are used hereinafter to describe the behavior of applying a layer of material to the substrate. Such terms are intended to describe any possible layer forming techniques including, but not limited to, thermal growth, sputtering, evaporation, chemical vapor deposition, epitaxial growth, electroplating, and the like.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer and/or section from another. Thus, a first element, component, region, layer or section discussed below could be termed a second element, component, region, layer or section without departing from the teachings of the disclosure.

In addition, the phrase "in a range between a first value and a second value" or "ranged from a first value to a second value" indicates that the range includes the first value, the second value, and other values between them.

It will be understood that several embodiments shown below describe different technical features respectively. But these technical features can also be mixed or combined in various ways if they are not conflict to each other.

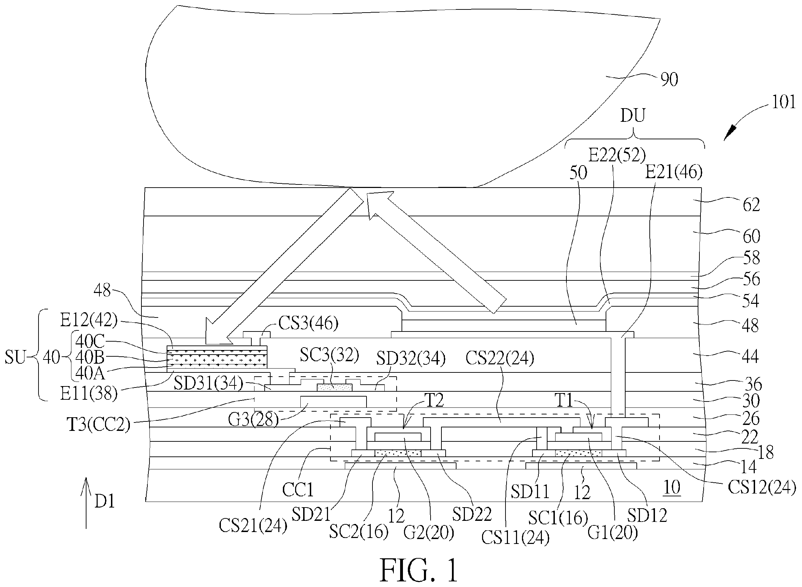

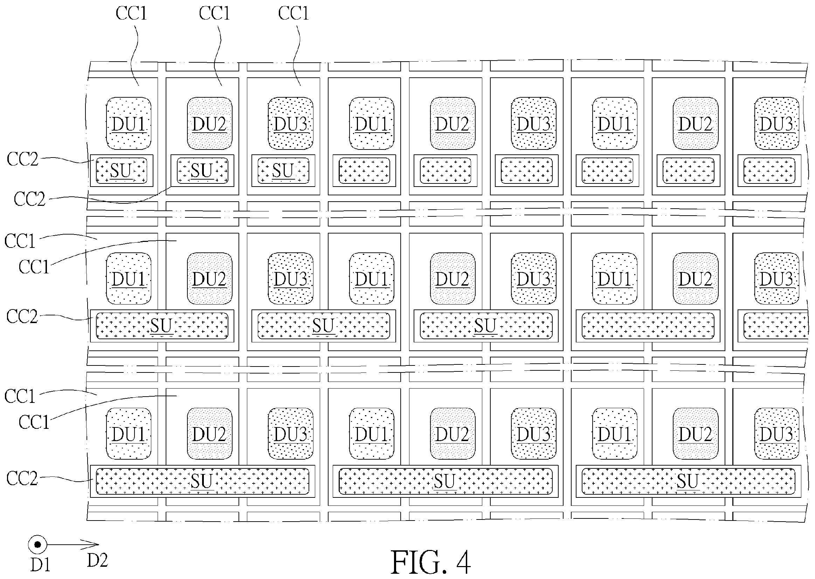

FIG. 1 is a schematic drawing illustrating a display device according to a first embodiment of the present disclosure. The display device may include mobile phones, televisions, monitors, tablet PCs, and laptop PCs, but not limited thereto. As shown in FIG. 1, a display device 101 is provided in this embodiment. The display device 101 may include a substrate 10, a driving circuit CC1, a plurality of sensing units SU, and a sensing circuit CC2. The driving circuit CC1 is disposed on the substrate 10 and may be configured for driving a plurality of display units DU. The sensing units SU may be disposed on the driving circuit CC1 and include a semiconductor layer (such as a third semiconductor layer 40 shown in FIG. 1). The sensing circuit CC2 may be configured for driving the sensing units SU and include a semiconductor layer (such as a second semiconductor layer 32 shown in FIG. 1). A thickness of the third semiconductor layer 40 may be greater than a thickness of the second semiconductor layer 32. It is worth noting that there is only one sensing unit SU and only one display unit DU shown in FIG. 1 for the simplicity of the figure, and a plurality of sensing units SU and a plurality of display units DU will be shown in another figure of the present disclosure (such as FIG. 4).

In some embodiments, the sensing unit SU may include an optical sensing unit (such as an optical sensor for fingerprint identification, but not limited thereto) or other suitable types of sensing units. The third semiconductor layer 40 may be used as a photoelectric conversion element, and the thickness of the third semiconductor layer 40 may be kept in a range for providing the required photoelectric conversion performance. For example, in some embodiments, the thickness of the third semiconductor layer 40 may be in a range from 5000 angstroms (Å) to 20000Å, such as 7500 Å, 10000 Å, 12500 Å, 15000 Å or 17500Å, but not limited thereto. In some embodiments, the sensing unit SU may include a photodiode including a first electrode E11, a first doped semiconductor layer 40A, an intrinsic semiconductor layer 40B, a second doped semiconductor layer 40C, and a second electrode E12 sequentially disposed in a normal direction of the substrate 10 (such as a first direction D1 shown in FIG. 1), but not limited thereto. The first doped semiconductor layer 40A and the second doped semiconductor layer 40C may be a first -type doped semiconductor layer and a second type doped semiconductor layer respectively. In some examples, one of the first type and the second type may be N-type, and the other one may be P-type. The sensing unit SU may include a PIN light sensing diode, but not limited thereto. The first doped semiconductor layer 40A, the intrinsic semiconductor layer 40B, and the second doped semiconductor layer 40C may constitute the third semiconductor layer 40 described above. Therefore, the thickness of the third semiconductor layer 40 may be substantially equal to the sum of the thickness of the first doped semiconductor layer 40A, the thickness of the intrinsic semiconductor layer 40B, and the thickness of the second doped semiconductor layer 40C in the first direction D1. In some examples, the term "thickness" of the present disclosure may refer to the maximum thickness in the first direction D1, but not limited thereto. In some embodiments, the material of the third semiconductor layer 40 may be amorphous, such as amorphous silicon (a-Si) or include other suitable amorphous semiconductor materials. The first doped semiconductor layer 40A may be a N-type doped amorphous silicon layer, the intrinsic semiconductor layer 40B may be an intrinsic amorphous silicon layer, and the second doped semiconductor layer 40C may be a P-type doped amorphous silicon layer, but not limited thereto. It is worth noting that the sensing unit SU in the present disclosure is not limited to the optical sensing unit described above, and other types of sensing unit, such as a force senor and a motion sensor, may also be applied to the present disclosure.

In some embodiments, the sensing circuit CC2 may include at least one transistor (such as a third transistor T3 shown in FIG. 1), and at least a part of the second semiconductor layer 32 may be a semiconductor channel layer SC3 of the third transistor T3, but not limited thereto. In some embodiments, the second semiconductor layer 32 may also be used to form other kinds of active and/or passive components in the sensing circuit CC2. In some embodiments, the material of the second semiconductor layer 32 may be amorphous, and the second semiconductor layer 32 may include amorphous silicon, amorphous germanium (a-Ge), amorphous indium gallium arsenide (a-InGaAs), amorphous metal oxide semiconductor material (such as amorphous indium gallium zinc oxide, a-IGZO), or other suitable amorphous semiconductor materials. However, the second semiconductor layer 32 may include a crystalline semiconductor material, such as microcrystalline silicon (uc-Si) and crystalline metal oxide semiconductor materials. In some embodiments, the thickness of the second semiconductor layer 32 in the first direction D1 may be in a range from 500Å to 3000Å, such as 750 Å, 1000 Å, 1500Å, 2000 Å, or 2500 Å, but not limited thereto. In some embodiments, a ratio of the thickness of the third semiconductor layer 40 in the sensing unit SU to the thickness of the second semiconductor layer 32 in the sensing circuit CC2 may be in a range from 1.5 to 40, such as 3, 5, 10, 20 or 30, but not limited thereto.

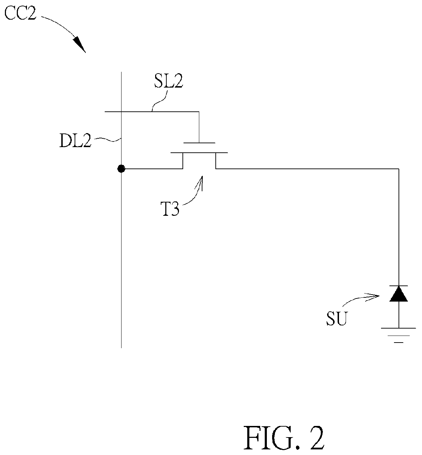

FIG. 2 is a schematic circuit diagram of the sensing circuit CC2 in this embodiment. As shown in FIG. 1 and FIG. 2, the third transistor T3 may include a gate electrode G3, a first source/drain electrode SD31, a second source/drain electrode SD32, a gate dielectric layer 30, and the semiconductor channel layer SC3. In some embodiments, the first source/drain electrode SD31 of the third transistor T3 may be electrically connected to the first electrode E11 of the sensing unit SU. The second source/drain electrode SD32 of the third transistor T3 may be electrically connected to a data line DL2. The gate electrode G3 of the third transistor T3 may be electrically connected to a scan line SL2, but not limited thereto. The second electrode E11 of the sensing unit SU may be electrically connected to a voltage source via a conductive structure CS3, and the third transistor T3 may be regarded as a sensing thin film transistor (TFT), but not limited thereto. In other words, the sensing circuit CC2 may include at least one sensing TFT electrically connected to at least one of the plurality of sensing units SU. The thickness of the third semiconductor layer 40 in the sensing unit SU may be kept in a range for providing the required performance, and the thickness of the third semiconductor layer 40 may be greater than the thickness of the second semiconductor layer 32 in the sensing circuit CC2 accordingly.

In some embodiments, the display unit DU may include an electroluminescent display unit, such as an organic light emitting diode (OLED), a light emitting diode (LED), a mini light emitting diode (mini LED), a micro light emitting diode (micro LED), other suitable types of display units, or a combination thereof. In some embodiments, the display unit DU may include a first electrode E21, a light emitting layer 50, and a second electrode E22 sequentially disposed in the first direction D1, but not limited thereto. In some embodiments, the driving circuit CC1 may include a first semiconductor layer 16, and the first semiconductor layer 16 may be disposed on a plane different from a plane where the second semiconductor layer 32 is disposed and a plane where the third semiconductor layer 40 is disposed. The material of the first semiconductor layer 16 may be different from the material of the second semiconductor layer 32 and/or the material of the third semiconductor layer 40. In some embodiments, the first semiconductor layer 16 may include a polycrystalline semiconductor layer, a metal oxide semiconductor layer, or other suitable semiconductor materials. For example, the first semiconductor layer 16 may include a poly-silicon (poly-Si) layer or a metal oxide semiconductor (such as IGZO) layer, but not limited thereto. The driving circuit CC1 may include at least one transistor (such as a first transistor T1 shown in FIG. 1), and at least a part of the first semiconductor layer 16 may be a semiconductor channel layer SC1 of the first transistor T1, but not limited thereto. In some embodiments, the first semiconductor layer 16 may also be used to form other kinds of active and/or passive components in the driving circuit CC1. In some embodiments, the thickness of the first semiconductor layer 16 in the first direction D1 may be in a range from 500Å to 1000Å, such as 600Å, 700Å, 800Å or 900Å, but not limited thereto. In some embodiments, a ratio of the thickness of the third semiconductor layer 40 in the sensing unit SU to the thickness of the first semiconductor layer 16 in the driving circuit CC1 may be in a range from 1.5 to 40, but not limited thereto.

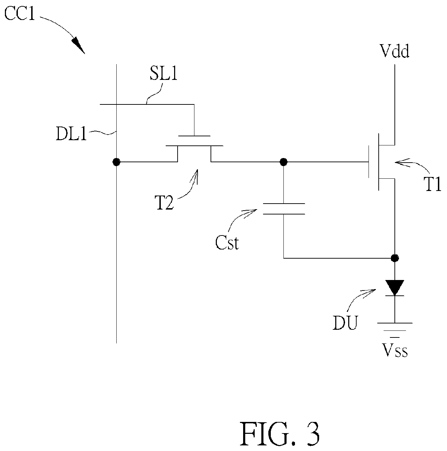

FIG. 3 is a schematic circuit diagram of the driving circuit CC1 in this embodiment. As shown in FIG. 1 and FIG. 3, the driving circuit CC1 may further include a second transistor T2 electrically connected to the first transistor T1. Specifically, the first transistor T1 may include a gate electrode G1, a first source/drain electrode SD11, a second source/drain electrode SD12, and the semiconductor channel layer SC1, and the second transistor T2 may include a gate electrode G2, a first source/drain electrode SD21, a second source/drain electrode SD22, and a semiconductor channel layer SC2. In some embodiments, a part of the first semiconductor layer 16 may be the semiconductor channel layer SC1 of the first transistor T1, and another part of the first semiconductor layer 16 may be the semiconductor channel layer SC2 of the second transistor T2, but not limited thereto. Additionally, a part of a gate dielectric layer 18 may be a gate dielectric layer of the first transistor T1, and another part of a gate dielectric layer 18 may be a gate dielectric layer of the second transistor T2, but not limited thereto. In some embodiments, the first source/drain electrode SD11 and the second source/drain electrode SD12 of the first transistor T1 may be doped regions in the first semiconductor layer 16, and the first source/drain electrode SD21 and the second source/drain electrode SD22 of the second transistor T2 may be doped regions in the first semiconductor layer 16, but not limited thereto.

In some embodiments, the first source/drain electrode SD11 of the first transistor T1 may be electrically connected to a first voltage terminal Vdd (such as a drain voltage terminal) via a conductive structure CS11. The second source/drain electrode SD12 of the first transistor T1 may be electrically connected to the first electrode E21 of the display unit DU via a conductive structure CS12. The gate electrode G1 of the first transistor T1 may be electrically connected to the second source/drain electrode SD22 of the second transistor T2 via a conductive structure CS22. In some examples, the conductive structure CS11 may be electrically isolated from the conductive structure CS22. In one cross-sectional view, the conductive structure CS11 and the conductive structure CS22 may not be seen at the same time, and only one of the conductive structure CS11 and the conductive structure CS22 may be seen, but not limited thereto. The first source/drain electrode SD21 of the second transistor T2 may be electrically connected to a data line DL1 via a conductive structure CS21. The gate electrode G2 of the second transistor T2 may be electrically connected to a scan line SL1. The second electrode E22 of the display unit DU may be electrically connected to a second voltage terminal Vss (such as a ground reference voltage terminal). A storage capacitor Cst may be electrically coupled to a node between the gate electrode G1 and the second source/drain electrode SD22 of the second transistor T2 and a node between the first electrode E21 and the second source/drain electrode SD12 of the first transistor T1, but not limited thereto.

Therefore, the first transistor T1 may be regarded as a driving TFT electrically connected to one of the plurality of display units DU, and the second transistor T2 may be regarded as a switching TFT electrically connected to the driving TFT. In other words, the driving circuit CC1 may include at least one driving TFT electrically connected to at least one of the plurality of display units DU and at least one switching TFT. In some embodiments, the material of the semiconductor channel layer SC2 of the switching thin film transistor (e.g. the second transistor T2) may be substantially the same as the material of the semiconductor channel layer SC1 of the driving thin film transistor (e.g. the first transistor T1). For example, the driving TFT (e.g. the first transistor T1) and the switching TFT (e.g. the second transistor T2) in the driving circuit C11 may include a poly-Si layer respectively, or the driving TFT (e.g. the first transistor T1) and the switching TFT (e.g. the second transistor T2) in the driving circuit C11 may include a metal oxide semiconductor layer respectively. In some embodiments, the material of the semiconductor channel layer SC2 of the switching TFT (e.g. the second transistor T2) may be different from the material of the semiconductor channel layer SC1 of the driving TFT (e.g. the first transistor T1). For example, the driving TFT (e.g. the first transistor T1) in the driving circuit C11 may include a metal oxide semiconductor layer, and the switching TFT (e.g. the second transistor T2) in the driving circuit C11 may include a poly-Si layer, but not limited thereto. Additionally, when the material of the first semiconductor layer 16 is different from the material of the second semiconductor layer 32, the material of the semiconductor channel layer SC3 of the at least one sensing TFT (e.g. the third transistor T3) may be different from the material of the semiconductor channel layer SC1 of the at least one driving TFT (e.g. the first transistor T1). In other words, the semiconductor material of the sensing TFT (e.g. the third transistor T3) in the sensing circuit CC2 may be different from the semiconductor material of the driving TFT (e.g. the first transistor T1) in the driving circuit CC1. The first semiconductor layer 16 and the second semiconductor layer 32 may be disposed on different planes and may be formed by different processes respectively. For example, the semiconductor channel layer SC3 of the sensing TFT (e.g. the third transistor T3) may include an amorphous semiconductor layer (such as an amorphous metal oxide semiconductor layer), and the semiconductor channel layer SC1 of the driving TFT (e.g. the first transistor T1) may include a polycrystalline semiconductor layer (such as a poly-silicon layer) for different operation considerations, such as lower leakage current, better current control, or lower power consumption, but not limited thereto.

FIG. 4 is a schematic top view drawing illustrating a display device according to an embodiment of the present disclosure. As shown in FIG. 1 and FIG. 4, in some embodiments, the display device may include a plurality of the display units DU, a plurality of the driving circuits CC1, a plurality of sensing units SU, and a plurality of the sensing circuits CC2 described above. In some embodiments, the sensing unit SU and the corresponding sensing circuit CC2 may overlap a part of the driving circuit CC1 in the first direction D1. Specifically, in some embodiments, the display units DU may emit different colors. For example, as shown in FIG.4, the first display units DU1 may emit a first color, the second display units DU2 may emit a second color, and the third display units DU3 may emit a third color, but not limited thereto. The first display units DU1, the second display units DU2, and the third display units DU3 may be alternately disposed in a horizontal direction (such as a second direction D2 shown in FIG. 4), but not limited thereto, the display units DU may be disposed in other arrangements. One display unit DU and the corresponding driving circuit CC1 may be disposed corresponding to one sub-pixel region. One sensing unit SU and the corresponding sensing circuit CC2 may overlap at least one sub-pixel region for different density requirements of the sensing units SU. In some embodiments, the sensing unit SU and the corresponding sensing circuit CC2 may overlap only one of the driving circuits CC1 in the first direction D1. In some embodiments, the sensing unit SU and the corresponding sensing circuit CC2 may overlap two or more of the driving circuits CC1 disposed adjacent to each other. In other words, the overlapping condition between the sensing units SU and the driving circuits CC1 may be adjusted according to the density or the resolution of the sensing units SU.

A manufacturing method of the display device 101 may include but is not limited to the following steps. As shown in FIG. 1, the substrate 10 is provided. The substrate 10 may include a glass substrate, a plastic substrate, a quartz substrate, a sapphire substrate, a ceramic substrate, or substrates including other suitable materials. Subsequently, the first transistor T1 and the second transistor T2 may be formed on the substrate 10. In some embodiments, a light shielding layer 12 and a buffer layer 14 may be formed on the substrate 10 before the step of forming the first transistor T1 and the second transistor T2. The material of the light shielding layer 12 may include resin, metal, polymer or other materials having high optical density (OD). The buffer layer 14 may include a single layer of a dielectric material, such as silicon oxide or silicon nitride, or a multiple layer structure including different dielectric materials, such as silicon oxide and silicon nitride, but not limited thereto. In some embodiments, the first semiconductor layer 16 may be formed on the buffer layer 14, but not limited thereto. The gate dielectric layer 18 may be formed on the first semiconductor layer 16, and a first conductive layer 20 may be formed on the gate dielectric layer 18. The first conductive layer 20 may be patterned to be the gate electrode G1 of the first transistor T1 and the gate electrode G2 of the second transistor T2. A first dielectric layer 22 may then be formed on the patterned first conductive layer 20 and the gate dielectric layer 18. The first dielectric layer 22 may include silicon oxide, silicon nitride, or other suitable dielectric materials. A plurality of contact holes may be formed and penetrate the first dielectric layer 22 or penetrating the first dielectric layer 22 and the gate dielectric layer 18. A second conductive layer 24 may be formed in the contact holes and formed on the first dielectric layer 22. The second conductive layer 24 may be patterned to be the conductive structure CS11, the conductive structure CS12, the conductive structure CS21, and the conductive structure CS22 described above, but not limited thereto.

Subsequently, a first passivation layer 26 may be formed on the second conductive layer 24 and the first dielectric layer 22. A third conductive layer 28 may then be formed on the first passivation layer 26, and the third conductive layer 28 may be patterned to be the gate electrode G3 of the third transistor T3. The gate dielectric layer 30 may be formed on the gate electrode G3. The second semiconductor layer 32 may be formed on the gate dielectric layer 30. After the step of forming the second semiconductor layer 32, a fourth conductive layer 34 may be formed on the gate dielectric layer 30. The fourth conductive layer 34 may be patterned to be the first source/drain electrode SD31 and the second source/drain electrode SD32 of the third transistor T3. A second passivation layer 36 may then be formed on the third transistor T3. The sensing unit SU may be formed on the second passivation layer 36. In some embodiments, a fifth conductive layer 38 may be partially formed on the second passivation layer 36 and partially formed in a contact hole exposing the first source/drain electrode SD31 of the third transistor T3 in the second passivation layer 36. The fifth conductive layer 38 may be patterned to be the first electrode E11 of the sensing unit SU. In some embodiments, the second electrode E12 of the sensing unit SU may be formed by a sixth conductive layer 42. It is worth noting that, in some embodiments, the third semiconductor layer 40 of the sensing unit SU may be formed after the step of forming the second semiconductor layer 32 of the sensing circuit CC2, but the present disclosure is not limited to this. In some embodiments (not shown), the third semiconductor layer 40 of the sensing unit SU may also be formed before the step of forming the second semiconductor layer 32 of the sensing circuit CC2.

After the step of forming the sensing unit SU, a planarization layer 44 may be formed on the second passivation layer 36 and the sensing unit SU. A seventh conductive layer 46 may be partially formed on the planarization layer 44, partly formed in a contact hole exposing a part of the second electrode E12 in the planarization layer 46. The seventh conductive layer 46 may also partially formed in a contact hole penetrating the planarization layer 44, the second passivation layer 36, the gate dielectric layer 30, and a part of the first passivation layer 26 and exposing a part of the conductive structure CS12. The seventh conductive layer 46 may be patterned to be the conductive structure CS3 and the first electrode E21 of the display unit DU. After the step of forming the seventh conductive layer 46, a pixel defining layer 48 may be formed on the planarization layer 44 and the seventh conductive layer 46 for forming a plurality of recess structures for the display units DU. The material of the planarization layer 44 and the material of the pixel defining layer 48 may respectively include an organic dielectric material (such as an acrylate-based polymer material and/or a siloxane based polymer material) or other suitable photopatternable materials, but not limited thereto. The light emitting layer 50 of the display unit DU may be formed in the recess structure, and an eighth conductive layer 52 may be formed on the light emitting layer 50 and the pixel defining layer 48. The eighth conductive layer 52 may be patterned to be the second electrode E22 of the display unit DU, and at least one dielectric layer may then be formed on the second electrode E22. For example, a second dielectric layer 54, a third dielectric layer 56, and/or a fourth dielectric layer 58 may be subsequently formed on the second electrode E22 of the display unit DU. In some embodiments, the third dielectric layer 56 may be an organic dielectric layer for planarization, and the second dielectric layer 54 and the fourth dielectric layer 58 may be inorganic dielectric layers (such as silicon oxide, silicon nitride, and silicon oxynitride) for protecting the display unit DU, but not limited thereto.

In some embodiments, a function layer 60 may be formed on the fourth dielectric layer 58, and a cover substrate 62 may be formed on the function layer 60, but not limited thereto. The function layer 60 may include functional units, such as capacitive touch sensing units, resistive touch sensing units, force sensing units, polarization units, or other units having other functions, but not limited thereto. The cover substrate 62 may include a transparent substrate, such as a glass substrate, a polymer substrate (such as a polyimide substrate), or a transparent substrate including other suitable materials. As shown in FIG. 1, when the sensing unit SU is an optical sensing unit, the light emitted from the display unit DU may be reflected by an object 90 (such as a human finger) touching the display device 101 and received by the sensing unit SU for detecting the object 90 touching the display device 101, but not limited thereto. The sensing unit SU can also receive light emitted from other light sources and reflected by the object 90, for instances, the light source may include an additional infrared light source or the environmental light, but not limited thereto.

In some embodiments, the material(s) of the first conductive layer 20, the second conductive layer 24, the third conductive layer 28, the fourth conductive layer 34, the fifth conductive layer 38, the sixth conductive layer 42, the seventh conductive layer 46, and the eighth conductive layer 52 described above may include a metallic conductive material, such as aluminum, molybdenum, copper, titanium, tungsten, or other suitable metallic conductive material, or a transparent conductive material, such as indium tin oxide (ITO) or other suitable transparent conductive materials. In some embodiments, the gate dielectric layer 18 and the gate dielectric layer 30 described above may include a single layer structure or a multiple layer structure including dielectric materials, such as silicon oxide, silicon nitride, aluminum oxide, or other suitable dielectric materials. In some embodiments, the first passivation layer 26 and the second passivation layer 36 may include silicon oxide, silicon nitride, silicon oxynitride, an organic passivation material, or other suitable insulation materials.

It is worth noting that the structures of the first transistor T1, the second transistor T2, and the third transistor T3 in the present disclosure are not limited to the condition shown in FIG. 1, and other suitable structural designs may also be applied to form the first transistor T1, the second transistor T2, and the third transistor T3 in the present disclosure. For example, the first transistor T1, the second transistor T2, and the third transistor T3 may include a top gate transistor, a bottom gate transistor, a dual gate transistor and a double gate transistor depending on the needs, but not limited thereto.

The following description will detail the different embodiments of the present disclosure. To simplify the description, identical components in the following embodiments are marked with identical symbols. For making it easier to understand the differences between the embodiments, the following description will detail the dissimilarities among different embodiments and the identical features will not be redundantly described.

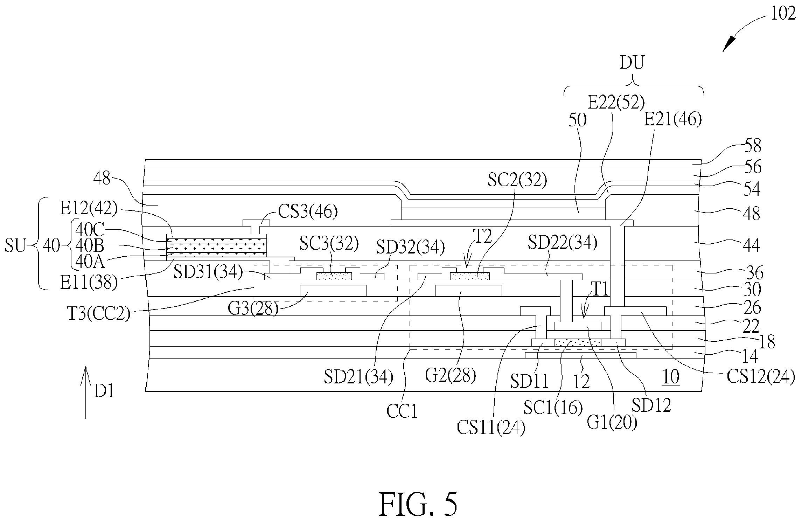

FIG. 5 is a schematic drawing illustrating a display device 102 according to a second embodiment of the present disclosure. In the display device 102, at least one transistor (e.g. the first transistor T1 and/or the second transistor T2) of the driving circuit CC1 and the third transistor T3 of the sensing circuit CC2 may be formed on the first passivation layer 26 by the same process(es). In some examples, the third transistor T3 of the sensing circuit CC2 may overlap the sensing unit SU. For example, the third conductive layer 28 may be patterned to be the gate electrode G2 of the second transistor T2 and the gate electrode G3 of the third transistor T3. The second semiconductor layer 32 may be patterned to be the semiconductor channel layer SC2 of the second transistor T2 and the semiconductor channel layer SC3 of the third transistor T3. The fourth conductive layer 34 may be patterned to be the first source/drain electrode SD21 and the second source/drain electrode SD22 of the second transistor T2 and the first source/drain electrode SD31 and the second source/drain electrode SD32 of the third transistor T3, but not limited thereto. In other words, the material of the semiconductor channel layer SC2 of the at least one switching TFT (e.g. the second transistor T2) in the driving circuit CC1 may be different from the material of the semiconductor channel layer SC1 of the at least one driving TFT (e.g. the first transistor T1) in the driving circuit CC1. The material of the semiconductor channel layer SC2 of the at least one switching TFT (e.g. the second transistor T2) in the driving circuit CC1 may be substantially the same as the material of the semiconductor channel layer SC3 of the at least one sensing TFT (e.g. the third transistor T3), but not limited thereto. When the second semiconductor layer 32 is a metal oxide semiconductor layer, the switching TFT (e.g. the second transistor T2) may include a metal oxide semiconductor layer. When the second semiconductor layer 32 is a metal oxide semiconductor layer and the first semiconductor layer 16 is a low temperature polysilicon (LTPS) semiconductor layer, the driving circuit CC1 may include at least one LTPS TFT (e.g. the first transistor T1) and at least one metal oxide TFT (e.g. the second transistor T2).

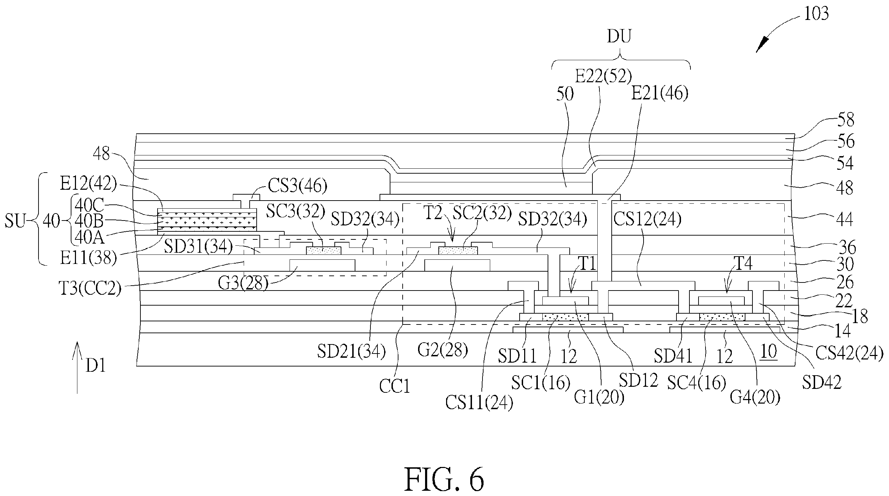

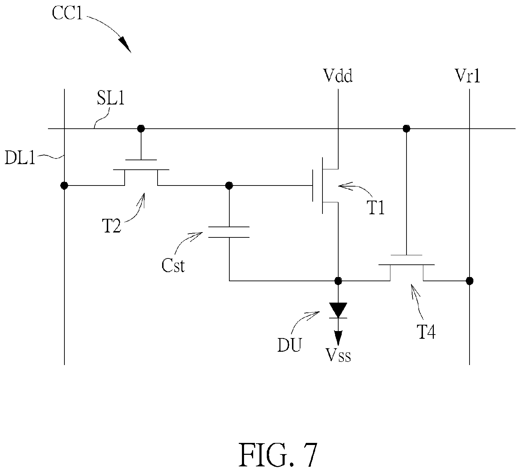

FIG. 6 is a schematic drawing illustrating a display device 103 according to a third embodiment of the present disclosure, and FIG. 7 is a schematic circuit diagram of the driving circuit CC1 in this embodiment. As shown in FIG. 6 and FIG. 7, in the display device 103, the driving circuit CC1 may further include a fourth transistor T4. The fourth transistor T4 may include a gate electrode G4, a first source/drain electrode SD41, a second source/drain electrode SD42, and a semiconductor channel layer SC4. In some embodiments, the first source/drain electrode SD41 may be electrically connected to the second source/drain electrode SD12 of the first transistor T1 and the first electrode E21 of the display unit DU via the conductive structure CS12. The second source/drain electrode SD42 may be electrically connected to a reference voltage terminal Vr1 via a conductive structure CS42. The gate electrode G4 may be electrically connected to the scan line SL1. The fourth transistor T4 may be regarded as a resetting TFT in the driving circuit CC1, but not limited thereto. In some embodiments, the fourth transistor T4 and the first transistor T1 of the driving circuit CC1 may be formed on the buffer layer 14 by the same process(es). For example, the first semiconductor layer 16 may be patterned to be the semiconductor channel layer SC1 of the first transistor T1 and the semiconductor channel layer SC4 of the fourth transistor T4. The first conductive layer 20 may be patterned to be the gate electrode G1 of the first transistor T1 and the gate electrode G4 of the fourth transistor T4. The second conductive layer 24 may be patterned to be the conductive structure CS11, the conductive structure CS12, and the conductive structure CS42, but not limited thereto. In some embodiments, the material of the first semiconductor layer 16 may be different from the material of the second semiconductor layer 32. In other words, the driving circuit CC1 may further include at least one resetting TFT (e.g. the fourth transistor T4) electrically connected to the driving TFT (e.g. the first transistor T1), and the material of the semiconductor channel layer SC4 of the at least one resetting TFT (e.g. the fourth transistor T4) may be different from the material of the semiconductor channel layer CS2 of the at least one switching TFT (e.g. the second transistor T2).

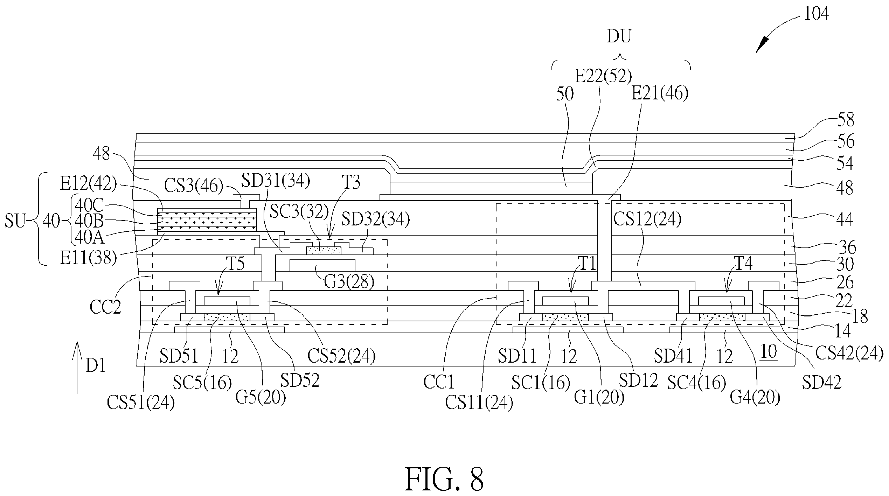

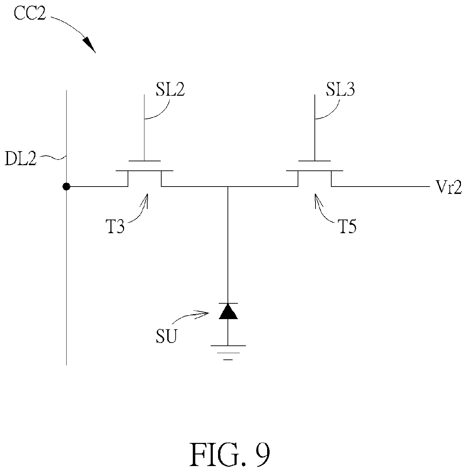

FIG. 8 is a schematic drawing illustrating a display device 104 according to a fourth embodiment of the present disclosure, and FIG. 9 is a schematic circuit diagram of the sensing circuit CC2 in this embodiment. As shown in FIG. 8 and FIG. 9, in the display device 104, the sensing circuit CC2 may further include a fifth transistor T5. The fifth transistor T5 may include a gate electrode G5, a first source/drain electrode SD51, a second source/drain electrode SD52, and a semiconductor channel layer SC5. In some embodiments, the first source/drain electrode SD51 may be electrically connected to a reference voltage terminal Vr2 via a conductive structure CS51. The second source/drain electrode SD52 may be electrically connected to the first source/drain electrode SD31 of the third transistor T3 and the first electrode E11 of the sensing unit SU via a conductive structure CS52. The gate electrode G5 may be electrically connected to a scan line SL3. The fifth transistor T5 may be regarded as a resetting TFT in the sensing circuit CC2, but not limited thereto. In some embodiments, the fifth transistor T5 of the sensing circuit CC2 and the first transistor T1 of the driving circuit CC1 may be formed on the buffer layer 14 by the same process(es). For example, the first semiconductor layer 16 may be patterned to be the semiconductor channel layer SC1 of the first transistor T1 and the semiconductor channel layer SC5 of the fifth transistor T5. The first conductive layer 20 may be patterned to be the gate electrode G1 of the first transistor T1 and the gate electrode G5 of the fifth transistor T5. The second conductive layer 24 may be patterned to be the conductive structure CS11, the conductive structure CS12, the conductive structure CS51, and the conductive structure CS52, but not limited thereto.

In some embodiments, the material of the first semiconductor layer 16 may be different from the material of the second semiconductor layer 32. In other words, the sensing circuit CC2 may further comprise at least one resetting TFT (e.g. the fifth transistor T5) electrically connected to the sensing TFT (e.g. the third transistor T3). The material of the semiconductor channel layer SC5 of the at least one resetting TFT (e.g. the fifth transistor T5) in the sensing circuit CC2 may be different from the material of the semiconductor channel layer SC3 of the at least one sensing TFT (e.g. the third transistor T3). The material of the semiconductor channel layer SC5 of the at least one resetting TFT (e.g. the fifth transistor T5) in the sensing circuit CC2 may be the same as the material of the semiconductor channel layer SC1 of the at least one driving TFT (e.g. the first transistor T1) in the driving circuit CC1, but not limited thereto. In some embodiments, the fifth transistor T5 may be disposed under the sensing unit SU in the first direction D1, and the third semiconductor layer 40 may overlap at least a part of the semiconductor channel layer SC5 in the first direction D1 accordingly, but not limited thereto.

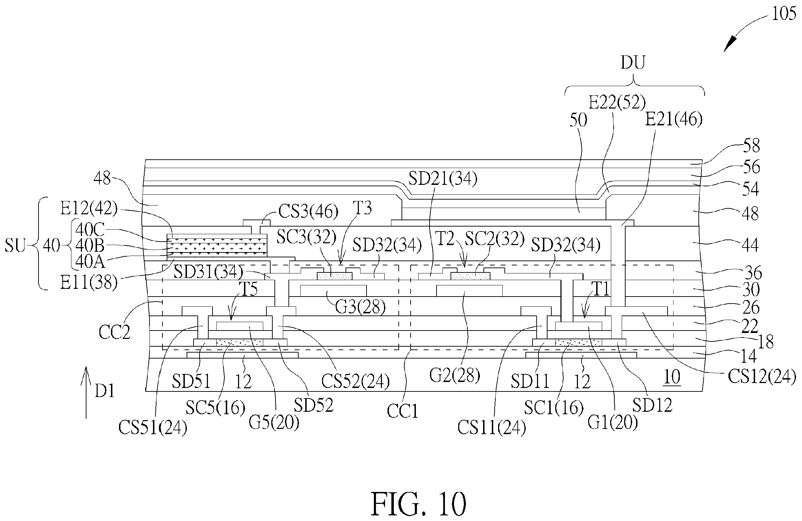

FIG. 10 is a schematic drawing illustrating a display device 105 according to a fifth embodiment of the present disclosure. As shown in FIG. 10, in the display device 105, the fifth transistor T5 of the sensing circuit CC2 and the first transistor T1 of the driving circuit CC1 may be formed on the buffer layer 14 by the same process(es). The third transistor T3 of the sensing circuit CC2 and the second transistor T2 of the driving circuit CC1 may be formed on the first passivation layer 26 by the same process(es). In other words, the driving circuit CC1 may include transistors including different semiconductor layers and disposed on different planes. The sensing circuit CC2 may also include transistors including different semiconductor layers and disposed on different planes. For example, when the second semiconductor layer 32 is a metal oxide semiconductor layer and the first semiconductor layer 16 is a LTPS semiconductor layer, the driving circuit CC1 may include at least one TFT (e.g. the first transistor T1) having a LTPS semiconductor layer and at least one TFT (e.g. the second transistor T2) having a metal oxide semiconductor layer, and the sensing circuit CC2 may also include at least one TFT (e.g. the fifth transistor T5) having a LTPS semiconductor layer and at least one metal oxide TFT (e.g. the third transistor T3) having the metal oxide semiconductor layer, but not limited thereto.

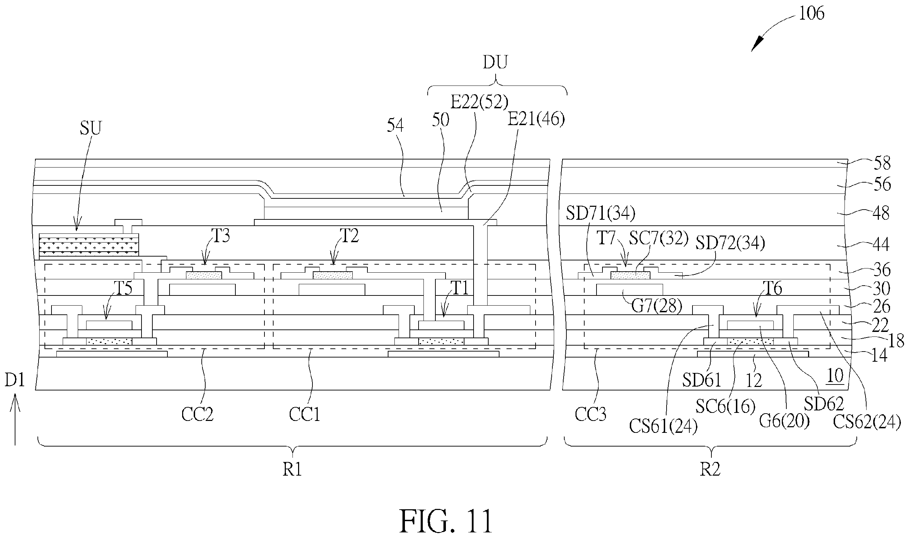

FIG. 11 is a schematic drawing illustrating a display device 106 according to a sixth embodiment of the present disclosure. As shown in FIG. 11, in the display device 106, a first region R1 and a second region R2 may be defined on the substrate 10. The driving circuit CC1, the display unit DU, the sensing circuit CC2, and the sensing unit SU described above may be disposed in the first region R1. In some embodiments, the first region R1 may be regarded as an active region and/or a display region, and the second region R2 may be regarded as a non-active region and/or a peripheral region, but not limited thereto. The display device 106 may further include a peripheral circuit CC3 disposed in the second region R2. The peripheral circuit CC3 may include a gate driver circuit, a data line driver circuit, a demultiplexer (DeMux), and/or other functional circuit units. In some embodiments, the peripheral circuit CC3 may include a sixth transistor T6 and a seventh transistor T7 disposed on different planes respectively. For example, the sixth transistor T6 of the peripheral circuit CC3 and the first transistor T1 of the driving circuit CC1 may be formed on the buffer layer 14 by the same process(es). The seventh transistor T7 of the peripheral circuit CC3 and the third transistor T3 of the sensing circuit CC2 may be formed on the first passivation layer 26 by the same processes. The sixth transistor T6 may include a gate electrode G6, a first source/drain electrode SD61, a second source/drain electrode SD62, and a semiconductor channel layer SC6. A conductive structure CS61 may be electrically connected to the first source/drain electrode SD61, and a conductive structure CS62 may be electrically connected to the second source/drain electrode SD62. The seventh transistor T7 may include a gate electrode G7, a first source/drain electrode SD71, a second source/drain electrode SD72, and a semiconductor channel layer SC7.

As shown in FIG. 11 and FIG. 10, in some embodiments, the first semiconductor layer 16 may be patterned to be the semiconductor channel layer SC1 of the first transistor T1 and the semiconductor channel layer SC6 of the sixth transistor T6. The first conductive layer 20 may be patterned to be the gate electrode G1 of the first transistor T1 and the gate electrode G6 of the sixth transistor T6. The second conductive layer 24 may be patterned to be the conductive structure CS11, the conductive structure CS12, the conductive structure CS61, and the conductive structure CS62, but not limited thereto. In some embodiments, the third conductive layer 28 may be patterned to be the gate electrode G7 of the seventh transistor T7 and the gate electrode G3 of the third transistor T3. The second semiconductor layer 32 may be patterned to be the semiconductor channel layer SC7 of the seventh transistor T7 and the semiconductor channel layer SC3 of the third transistor T3. The fourth conductive layer 34 may be patterned to be the first source/drain electrode SD71 and the second source/drain electrode SD72 of the seventh transistor T7 and the first source/drain electrode SD31 and the second source/drain electrode SD32 of the third transistor T3, but not limited thereto. When the second semiconductor layer 32 is a metal oxide semiconductor layer and the first semiconductor layer 16 is a LTPS semiconductor layer, the peripheral circuit CC3 may include at least one TFT (e.g. the sixth transistor T6) having a LTPS semiconductor layer and at least one TFT (e.g. the seventh transistor T7) having a metal oxide semiconductor layer, but not limited thereto. It is worth noting that the peripheral circuit CC3 in this embodiment may also be applied to other embodiments (such as the embodiments described above) of the present disclosure. Although FIG. 11 only illustrates the sixth transistor T6 and the seventh transistor T7 in the peripheral circuit CC3, the peripheral circuit CC3 may include more transistors depending on the needs.

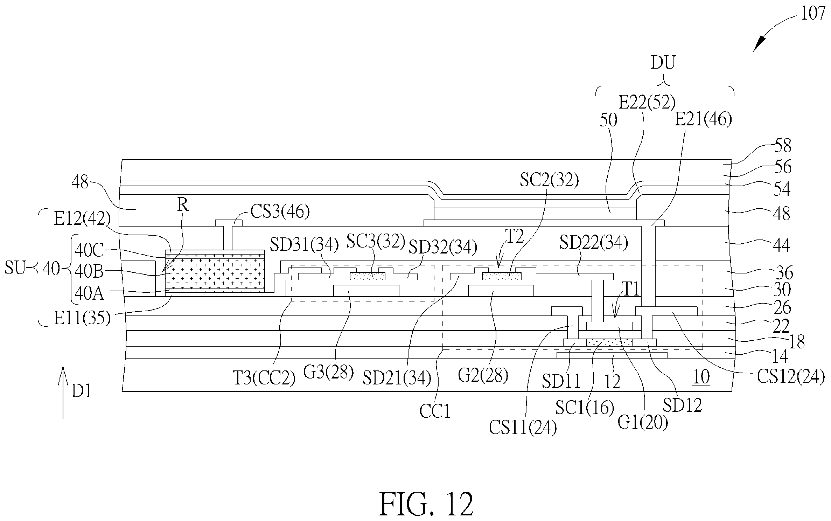

FIG. 12 is a schematic drawing illustrating a display device 107 according to a seventh embodiment of the present disclosure. As shown in FIG. 12, in the display device 107, at least a part of the sensing unit SU may be disposed in a recess R penetrating the second passivation layer 36 and/or the gate dielectric layer 30. In some embodiments, after the step of forming the third transistor T3, a recess R may be formed by removing a part of the gate dielectric layer 30, and the first electrode E11 may be partly formed in the recess R and partly formed on the first source/drain electrode SD31 of the third transistor T3 subsequently. The first electrode E11 may be formed by patterning another conductive layer 35, but not limited thereto. The material of the conductive layer 35 may include a metallic conductive material, such as aluminum, molybdenum, copper, titanium, tungsten, or other suitable metallic conductive materials, or a transparent conductive material, such as indium tin oxide, or other suitable transparent conductive materials. The second passivation layer 36 may be formed after the step of forming the first electrode E11, a part of the second passivation layer 36 may be removed for exposing a part of the first electrode E11. The third semiconductor layer 40 and the second electrode E12 may be formed on the first electrode E11 subsequently. The purpose of forming the recess R for the sensing unit SU may be that since the sensing unit SU may be thicker than other layers of the display device 107, disposing the sensing unit SU in the recess R may control the overall thickness of the display device 107. Besides, it may be easier for the planarization layer 44 to planarize or flatten the topography formed by the TFTs and/or the passivation layers, thereby providing a relatively flat plane before forming the display unit DU.

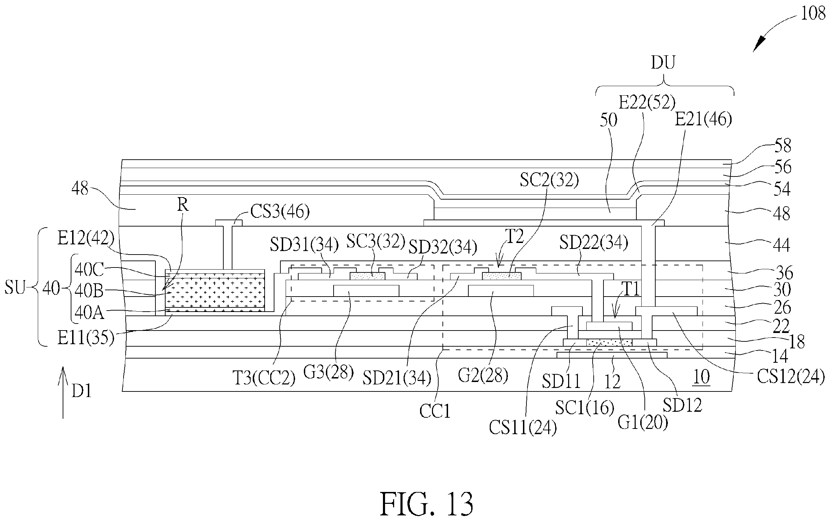

FIG. 13 is a schematic drawing illustrating a display device 108 according to an eighth embodiment of the present disclosure. As shown in FIG. 13, in the display device 108, at least a part of the sensing unit SU may be disposed in a recess R penetrating the second passivation layer 36, the gate dielectric layer 30, and the first passivation layer 26. In some embodiments, after the step of forming the third transistor T3, a recess R may be formed by removing a part of the gate dielectric layer 30 and a part of the first passivation layer 26 for exposing a part of the first dielectric layer 22, and the first electrode E11 may be partially formed in the recess R and partly formed on the first source/drain electrode SD31 of the third transistor T3 subsequently. The second passivation layer 36 may be formed after the step of forming the first electrode E11, a part of the second passivation layer 36 may be removed for exposing a part of the first electrode E11, and the third semiconductor layer 40 and the second electrode E12 may be formed on the first electrode E11 subsequently.

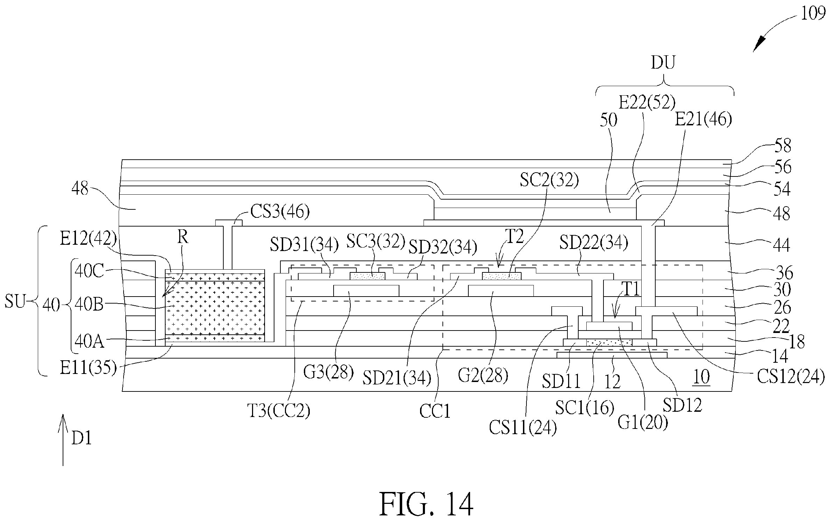

FIG. 14 is a schematic drawing illustrating a display device 109 according to a ninth embodiment of the present disclosure. As shown in FIG. 14, in the display device 109, at least a part of the sensing unit SU may be disposed in a recess R penetrating the second passivation layer 36, the gate dielectric layer 30, the first passivation layer 26, the first dielectric layer 22, and the gate dielectric layer 18. In some embodiments, after the step of forming the third transistor T3, a recess R may be formed by removing a part of the gate dielectric layer 30, a part of the first passivation layer 26, a part of the first dielectric layer 22, and a part of the gate dielectric layer 18 for exposing a part of the buffer layer 14, and the first electrode E11 may be partially formed in the recess and partially formed on the first source/drain electrode SD31 of the third transistor T3 subsequently. The recesses R illustrated in the figures of the present disclosure are only for exemplary illustration, in some examples, the edge of at least one of the recesses may have a gradual slope, or the bottom of the at least one of the recesses may be curved. The second passivation layer 36 may be formed after the step of forming the first electrode E11, a part of the second passivation layer 36 may be removed for exposing a part of the first electrode E11, and the third semiconductor layer 40 and the second electrode E12 may be formed on the first electrode E11 subsequently.

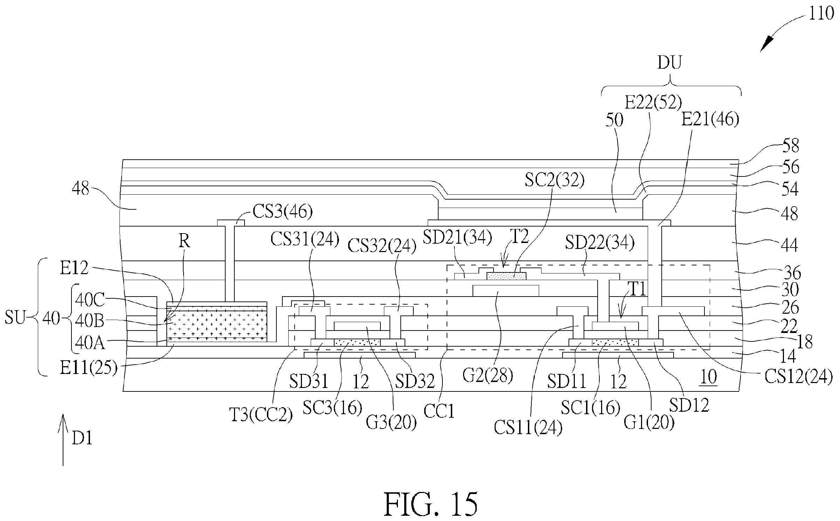

FIG. 15 is a schematic drawing illustrating a display device 110 according to a tenth embodiment of the present disclosure. As shown in FIG. 15, in the display device 110, the third transistor T3 of the sensing circuit CC2 and the first transistor T1 of the driving circuit CC1 may be formed on the buffer layer 14 by the same process(es). For example, the first semiconductor layer 16 may be patterned to be the semiconductor channel layer SC1 of the first transistor T1 and the semiconductor channel layer SC3 of the third transistor T3. The first conductive layer 20 may be patterned to be the gate electrode G1 of the first transistor T1 and the gate electrode G3 of the third transistor T3. The second conductive layer 24 may be patterned to be the conductive structure CS11, the conductive structure CS12, a conductive structure CS31 electrically connected to the first source/drain electrode SD31 of the third transistor T3, and a conductive structure CS32 electrically connected to the second source/drain electrode SD32 of the third transistor T3, but not limited thereto. In some embodiments, at least a part of the sensing unit SU may be disposed in a recess R penetrating the first passivation layer 26, the first dielectric layer 22, and the gate dielectric layer 18. For example, after the step of forming the third transistor T3 and the step of forming the conductive structure CS31 and the conductive structure CS32, a recess R may be formed by removing a part of the first dielectric layer 22 and a part of the gate dielectric layer 18 for exposing a part of the buffer layer 14, and the first electrode E11 may be partly formed in the recess R and partially formed on the conductive structure CS31 subsequently. The first passivation layer 26 may be formed after the step of forming the first electrode E11, a part of the first passivation layer 26 may be removed for exposing a part of the first electrode E11, and the third semiconductor layer 40 and the second electrode E12 may be formed on the first electrode E11 subsequently. In some embodiments, the gate dielectric layer 30 and the semiconductor channel layer SC2 of the second transistor T2 may be formed after the step of forming the sensing unit SU, and the second semiconductor layer 32 may be formed after the step of forming the third semiconductor layer 40 accordingly, but not limited thereto.

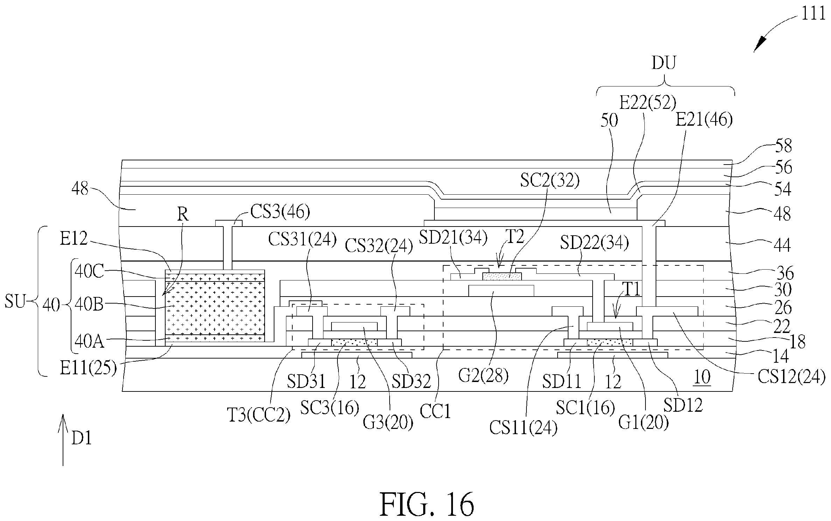

FIG. 16 is a schematic drawing illustrating a display device 111 according to an eleventh embodiment of the present disclosure. As shown in FIG. 16, in the display device 111, at least a part of the sensing unit SU may be disposed in a recess R penetrating the gate dielectric layer 30, the first passivation layer 26, the first dielectric layer 22, and the gate dielectric layer 18. In some embodiments, after the step of forming the third transistor T3 and the step of forming the conductive structure CS31 and the conductive structure CS32, a recess R may be formed by removing a part of the first dielectric layer 22 and a part of the gate dielectric layer 18 for exposing a part of the buffer layer 14. The first electrode E11 may be partially formed in the recess and partially formed on the conductive structure CS31 subsequently. The first passivation layer 26, the gate electrode G2 of the second transistor T2, and the gate dielectric layer 30 may be formed after the step of forming the first electrode E11, a part of the first passivation layer 26 and a part of the gate dielectric layer 30 may be removed for exposing a part of the first electrode E11, and the third semiconductor layer 40 and the second electrode E12 may be formed on the first electrode E11 subsequently. In some embodiments, the semiconductor channel layer SC2 of the second transistor T2 may be formed after the step of forming the sensing unit SU, and the second semiconductor layer 32 may be formed after the step of forming the third semiconductor layer 40 accordingly, but not limited thereto.

To summarize the above descriptions, in the display device of the present disclosure, the thickness of the semiconductor layer in the sensing unit may be greater than the thickness of the semiconductor layer in the sensing circuit for improving the sensing performance of the display device integrated with the sensing function. In addition, the material of the semiconductor channel layer of the sensing TFT in the sensing circuit may be different from the material of the semiconductor channel layer of the driving TFT in the driving circuit for different operation considerations in the sensing circuit and the driving circuit, and the performance of the display device and the process integration between driving circuit and the sensing circuit in the display device may be improved accordingly.

## Claims

1. A display device (101, 102, 103, 104, 105, 106, 107, 108, 109, 110, or 111), **characterized by**, comprising:
a substrate (10);
a driving circuit (CC1) disposed on the substrate (10) and for driving a plurality of display units (DU);
a plurality of sensing units (SU) disposed on the driving circuit (CC1) and comprising a first semiconductor layer (40); and
a sensing circuit (CC2) for driving the plurality of sensing units (SU) and comprising a second semiconductor layer (32 or 16);
wherein a thickness of the first semiconductor layer (40) is greater than a thickness of the second semiconductor layer (32 or 16).

2. The display device according to claim 1, **characterized in that**, a material of the first semiconductor layer (40) comprises an amorphous semiconductor material.

3. The display device according to claim 1 or 2, **characterized in that**, a material of the second semiconductor layer (32) comprises an amorphous semiconductor material.

4. The display device according to any of claims 1-3, **characterized in that**, the thickness of the first semiconductor layer (40) is in a range from 5000Å to 20000Å.

5. The display device according to any of claims 1-4, **characterized in that**, the thickness of the second semiconductor layer (32) is in a range from 500Å to 3000Å.

6. The display device according to any of claims 1-5, **characterized in that**, the driving circuit (CC1) comprises a semiconductor layer (16), and a ratio of the thickness of the first semiconductor layer (40) to a thickness of the semiconductor layer (16) in the driving circuit is in a range from 1.5 to 40.

7. The display device according to claim 1, **characterized in that**, the driving circuit (CC1) comprises:
a driving thin film transistor (T1) electrically connected to one of the plurality of display units (DU); and
a switching thin film transistor (T2) electrically connected to the driving thin film transistor (T1).

8. The display device according to claim 7, **characterized in that**, the driving thin film transistor (T1) comprises a polycrystalline silicon semiconductor layer.

9. The display device according to claim 7 or 8, **characterized in that**, the switching thin film transistor (T2) comprises a metal oxide semiconductor layer.

10. The display device according to claim 7 or 9, **characterized in that**, the driving thin film transistor (T1) comprises a metal oxide semiconductor layer.

11. The display device according to any of claims 7, 8 and 10, **characterized in that**, the switching thin film transistor (T2) comprises a poly-silicon semiconductor layer.

12. The display device according to any of claims 1-6, **characterized in that**, the driving circuit (CC1) comprises at least one low temperature polysilicon thin film transistor and at least one metal oxide thin film transistor.

13. The display device according to any of claims 1-6, **characterized in that**, the driving circuit (CC1) comprising a third semiconductor layer (16), and a material of the second semiconductor layer (32) is different from a material of the third semiconductor layer (16).

14. The display device according to any of claims 1-6, **characterized in that**, the driving circuit (CC1) further comprises at least one driving thin film transistor (T1) and at least one switching thin film transistor (T2) electrically connected to the driving thin film transistor (T1), and a material of a semiconductor channel layer (SC2) of the at least one switching thin film transistor (T2) is different from the material of the semiconductor channel layer (SC1) of the at least one driving thin film transistor (T1).

15. The display device according to claim 14, **characterized in that**, the material of the semiconductor channel layer (SC2) of the at least one switching thin film transistor (T2) is the same as a material of the second semiconductor layer (32).
